Europäisches Patentamt

European Patent Office

Office européen des brevets

(11) Veröffentlichungsnummer: **0 105 963**
**A1**

## (12) EUROPÄISCHE PATENTANMELDUNG

(21) Anmeldenummer: 82109582.5

(22) Anmeldetag: 16.10.82

(51) Int. Cl.³: **H 01 P 1/17, H 01 P 1/195**

(43) Veröffentlichungstag der Anmeldung: 25.04.84
Patentblatt 84/17

(84) Benannte Vertragsstaaten: BE CH DE FR GB IT LI NL SE

(71) Anmelder: ANT Nachrichtentechnik GmbH,
Gerberstrasse 33, D-7150 Backnang (DE)

(72) Erfinder: Mörz, Günter, Dr. Ing., Moserstrasse 19,
D-7140 Ludwigsburg (DE)

(74) Vertreter: Schickle, Gerhard, Dipl.-Ing. et al, ANT
Nachrichtentechnik GmbH Patent- und Lizenzabteilung
Gerberstrasse 33, D-7150 Backnang (DE)

(54) **Polarisationswandler.**

(57) Der Polarisationswandler besteht aus einem Wellenleiter (1, 13, 14) mit darin längs seiner Achse angeordneten Mitteln, die ein Bezugssystem (x', y') bilden aus senkrecht aufeinanderstehenden Längsschnittebenen, in denen die orthogonalen Komponenten einer in den Wellenleiter eingespeisten Welle unterschiedlich grosse Phasendrehungen erfahren. Um dieses Bezugssystem sehr schnell in jede beliebige Winkellage gegenüber der eingespeisten Welle einstellen bzw. es einer Rotation mit sehr hoher Winkelgeschwindigkeit aussetzen zu können, sind ortsfest um die Wellenleiterachse verteilt steuerbare magnetische und/oder elektrische Eigenschaften aufweisende Mittel (Ferrit (2), Dioden (15, 16, 17, 18) angeordnet, wobei durch Einwirken auf die magnetischen und/oder elektrischen Eigenschaften der einer wählbaren radialen Richtung zugeordneten Mittel das Bezugssystem eine dieser Richtung entsprechende Orientierung erhält.

- 1 -

AEG-TELEFUNKEN                                      K1 E7/Th/kön
Nachrichtentechnik GmbH                            BK 82/10
Gerberstr. 33
D-7150 Backnang


Polarisationswandler


Die vorliegende Erfindung betrifft einen Polarisationswandler
für Mikrowellen, bestehend aus einem Wellenleiter mit darin
längs seiner Achse angeordneten Mitteln, die ein Bezugssystem
bilden aus senkrecht aufeinanderstehenden Längsschnittebenen,
in denen die orthogonalen Komponenten einer in den Wellenleiter
eingespeisten Welle unterschiedlich große Phasendrehungen erfahren, wobei das Bezugssystem um die Längsachse des Wellenleiters drehbar ist.

Ein derartiger Polarisationswandler ist aus der amerikanischen
Patentschrift 2 607 849 bekannt. Dabei ist in einem Rundhohlleiter in Wellenausbreitungsrichtung eine dielektrische Platte
angeordnet. Diese Platte stellt das oben erwähnte orthogonale
Bezugssystem dar. Denn eine parallel zu der dielektrischen Platte verlaufende Wellenkomponente erfährt eine von der Länge der
Platte abhängige Phasenverschiebung, wohingegen die dazu senkrecht orientierte Wellenkomponente nahezu unverzögert den Hohlleiter durchläuft.

Gemäß der US-PS 2 607 849 ist die dielektrische Platte um die Hohlleiterachse drehbar gelagert, wodurch das Bezugssystem unter jeden beliebigen Winkel zu der Polarisationsebene der eingespeisten Welle ausgerichtet werden kann. Von der Lage des Bezugssystems relativ zu der Polarisationsebene der eingespeisten Welle hängen die Beträge der auf das Bezugssystem ausgerichteten orthogonalen Wellenkomponenten ab, so daß durch Verdrehen der dielektrischen Platte z.B. die Elliptizität einer Welle beeinflußt oder deren Polarisationsrichtung geändert werden kann. Schließlich findet ein solcher Polarisationswandler Anwendung als variabler Phasenschieber, sofern der Polarisationswandler 180°- Phasendrehung zwischen den orthogonalen Ebenen des Bezugssystems aufweist und zwischen 90° -Polarisationswandlern angeordnet ist.

Der der US-PS 2 607 849 zugrunde liegende Polarisationswandler hat zwar den Vorteil, daß sein Bezugssystem in jede beliebige Winkellage gebracht und somit einer Welle uneingeschränkt jede gewünschte Phasendrehung verliehen werden kann. Da hier aber die Ausrichtung des Bezugssystems auf rein mechanischem Wege mittels der axial drehbar gelagerten dielektrischen Platte erfolgt, sind der Winkelgeschwindigkeit des Bezugssystems sehr enge Grenzen gesetzt.

Der Erfindung liegt daher die Aufgabe zugrunde, einen Polarisationswandler der eingangs genannten Art zu schaffen, dessen Bezugssystem so realisiert ist, daß es sehr schnell in jede beliebige Winkellage gegenüber der Polarisationsebene der eingespeisten Welle eingestellt, bzw. daß es einer bis zu sehr hohen Winkelgeschwindigkeiten reichenden, kontinuierlichen Rotation ausgesetzt werden kann.

Den Kennzeichen der Ansprüche 1 und 11 sind zwei erfindungsgemäße, nebengeordnete Lösungen dieser Aufgabe zu entnehmen.

Zweckmäßige Ausführungen und vorteilhafte Verwendungsmöglichkeiten der Erfindung gehen aus den Unteransprüchen hervor.

Erst der erfindungsgemäße Polarisationswandler ermöglicht es,
auf sehr einfache Weise z.B. einen endlos drehenden Phasenschieber oder einen Phasen- bzw. Frequenzmodulator zu realisieren, der sehr verlustarm (<1dB Dämpfung) arbeitet. Außerdem vermeidet ein solch elektrisch gesteuerter Polarisationswandler die üblicherweise bei einer Anordnung mit mechanisch
beweglichen Teilen entstehenden Störeinflüsse auf die durchlaufende Welle.

Anhand von in der Zeichnung dargestellten Ausführungsbeispielen wird nun die Erfindung näher erläutert.

Es zeigen:

Fig. 1 einen Polarisationswandler, bestehend aus einem
Hohlleiter mit einem darin angeordneten quermagnetisierten Ferritkern,

Fig. 2 einen Hohlleiter, in dem die Längsschnittebenen
angedeutet sind, in denen das magnetische Feld der
Hohlleiterwelle zirkular polarisiert ist,

Fig. 3 einen Polarisationswandler mit quermagnetisiertem
Ferritkern, der hinsichtlich Hochfrequenzeigenschaften und Magnetisierung optimiert ist,

Fig. 4 die Vorderansicht und

Fig. 5 die perspektivische Darstellung eines Polarisationswandlers mit in einem koaxialen Hohlleiter
radial angeordneten Dioden,

Fig. 6 einen mit dem erfindungsgemäßen Polarisationswandler realisierten Phasenschieber und

Fig. 7 einen mit dem erfindungsgemäßen Polarisationswandler realisierten Mikrowellenkombinator.

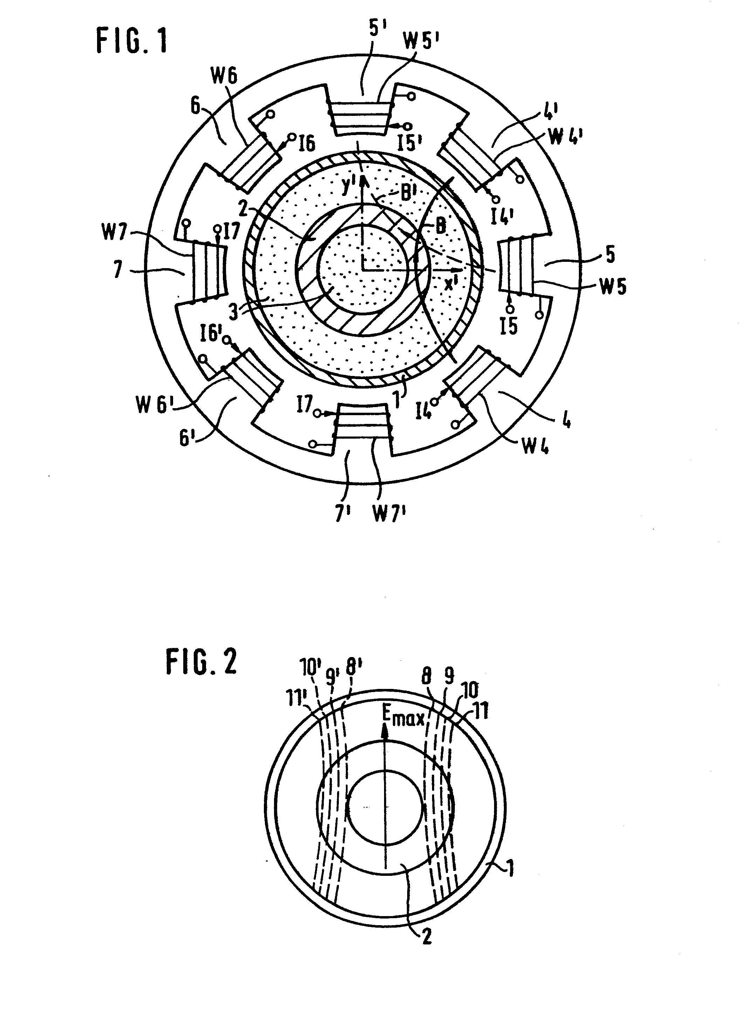

Der Fig. 1 ist die Vorderansicht eines Polarisationswandlers in Gestalt eines Rundhohlleiters 1 mit einem darin koaxial angeordneten Ferritkern 2, der hier rohrförmig ausgebildet ist, zu entnehmen. Dieser rohrförmige Ferritkern ist im Hohlleiter in einem dielektrischen Material 3 eingebettet.

Die anisotropen Eigenschaften des Ferrits werden ausgenutzt, um im Hohlleiter ein Bezugssystem aus senkrecht aufeinander stehenden Längsschnittebenen mit unterschiedlichen Wellenausbreitungseigenschaften zu bilden. Dadurch, daß der Ferritkern 2 einem Magnetfeld B ausgesetzt wird, richten sich die magnetischen Momente der Weiss-Bezirke parallel zu diesem äußeren Magnetfeld aus. Erfindungsgemäß ist das äußere Magnetfeld B, wie aus der Fig. 1 hervorgeht, senkrecht zur Achse des sich in Längsrichtung des Hohlleiters erstreckenden Ferritkerns orientiert. Sowohl der Ferritkörper als auch das äußere magnetische Feld B sollten dabei auf Längsschnittebenen im Hohlleiter konzentriert sein, in denen das hochfrequente Magnetfeld der sich im Hohlleiter ausbreitenden $H_{11}$-Welle zirkulare Polarisation aufweist. Im Rundhohlleiter verlaufen diese Ebenen symmetrisch zur Längsschnittebene, in der die maximale Feldstärke $E_{max}$ der sich ausbreitenden Welle liegt. Bei dem in Fig. 2 im Querschnitt gezeichneten Rundhohlleiter 1 sind die soeben angesprochenen Ebenen zirkularer Polarisation durch strichlierte Linien 8, 9, 10, 11 und 8', 9', 10', 11' angedeutet. Die Lage dieser Längsschnittebenen ist von der Betriebsfrequenz abhängig. So sind z.B. die Ebenen 8, 8' der Frequenz 3,5 GHz, die Ebenen 9,9' der Frequenz 3,7 GHz, die Ebenen 10, 10' der Frequenz 3,9 GHZ und die Ebenen 11, 11' der Frequenz 4,1 GHz zugeordnet. In

BK 82/10
0105963

den rechts und links der maximalen Feldstärke $E_{max}$ liegenden Längsschnittebenen ist das hochfrequente Magnetfeld mit entgegengesetztem Drehsinn polarisiert. Eine Veränderung der Ausbreitungseigenschaften der Welle läßt sich nur dann erreichen, wenn der Ferritkörper 2 in den Ebenen mit gegensinnig drehender Magnetfeldstärke auch durch ein gegensinnig gepoltes oder zumindest ungleichstarkes äußeres Magnetfeld B vormagnetisiert wird.

Man wird die Ausdehnung des Ferritkörpers in radialer Richung - bei dem rohrförmigen Ferritkern 2 (s. Fig. 1,2) also den Innen- und Außendurchmesser - so wählen, daß alle die zu einem gewünschten Frequenzbereich gehörenden Längsschnittebenen zirkularer Polarisation vom Ferritkörper geschnitten werden. Eine Welle, die nun längs des Ferritkerns verläuft und dabei in Richtung der magnetischen Momente des Ferrits polarisiert ist, erfährt eine von der Länge des Ferritkerns abhängige Laufzeitänderung bzw. Phasenverschiebung. Eine hierzu senkrecht polarisierte Welle bleibt dagegen in ihrer Phase nahezu unverändert. Der in der soeben beschriebenen Weise magnetisierte Ferritkern stellt also ein Bezugssystem (in der Fig. 1 durch das Koordinatensystem x', y' gekennzeichnet) dar, welches die orthogonalen, in x'- und y'-Richtung weisenden Komponenten einer in den Hohlleiter eingespeisten Welle einer gegenseitigen Phasenverschiebung aussetzt. Wie schon angesprochen, ist die resultierende Phasendifferenz der zwei orthogonalen Wellenkomponenten von der Länge des Ferrits, den sie passieren, abhängig und von der Größe des äußeren Magnetfeldes.

Damit läßt sich z.B. ein Polarisationswandler realisieren, der eine linear polarisierte Welle in eine zirkular polarisierte Welle umwandelt (bzw. umgekehrt), wenn das Bezugssystem unter einem Winkel von 45° zur eingespeisten Welle ausgerichtet wird und wenn es sich in Ausbreitungsrichtung so weit erstreckt, daß die orthogonalen Wellenkomponenten eine gegenseitige Phasenverschiebung von 90° erfahren. Bei Abweichung des Bezugssystems aus der 45°-Winkellage gegenüber der Polarisationsebene der linear polarisierten Welle erzeugt dieser 90°-Polarisationswandler eine elliptisch polarisierte Welle. Der Grad der Elliptizität läßt sich also sowohl durch eine entsprechende Verdrehung des Bezugssystems (Richtung der Magnetisierung) gegenüber der Polarisationsebene der linear polarisierten Welle, als auch durch die Stärke der Magnetisierung einstellen. Beide Maßnahmen, die Änderung der Richtung und der Stärke des Magnetfeldes, ermöglichen es, jedes beliebige Achsenverhältnis und jede beliebige Achsenlage der Polarisationsellipse zu erzeugen. Die beliebige Variation des Achsenverhältnisses mit nur magnetischen Mitteln eröffnet eine Fülle von Anwendungen z.B. in der Antennentechnik. Dort kann mit dem erfindungsgemäßen Polarisationswandler das Achsenverhältnis der Polarisationsellipse in der Antenne an die Einflüsse der Übertragungsstrecke angepaßt bzw. optimiert werden.

Besondere Bedeutung kommt einem 180°-Polarisationswandler zu, dessen Bezugssystem eine solche axiale Länge bzw. eine solche Stärke der Magnetisierung aufweist, daß die orthogonalen Wellenkomponenten gegeneinander um 180° phasenverschoben werden. Dieser 180°-Polarisationswandler dreht die Polarisationsebene einer linear polarisierten Welle um einen Winkel, der von dem Winkel abhängt, um den das Bezugssystem gegenüber der Polarisationsebene der in den Polarisationswandler eintretenden Welle verdreht worden ist. Eine zirkular polarisierte Welle erfährt beim Durchlaufen des 180°-Polarisationswandlers eine Drehrichtungsumkehr. Ordnet man den 180°-Polarisationswandler zwischen feststehenden 90°-Polarisationswandlern an, so ergibt sich eine der Verdrehung des Bezugssystems proportionale Phasendrehung zwischen dem Eingangs- und Ausgangssignal des Gesamtsystems. Somit läßt sich dieser Polarisationswandler auch als Phasenschieber ausnutzen. Auf die

0105963

BK 82/10

Realisierung eines Phasenschiebers mit einem 180°-Polarisationswandler wird weiter unten noch eingegangen.

Die soeben vorgestellten Anwendungsmöglichkeiten eines Polarisationswandlers lassen erkennen, daß es von enormem Vorteil ist, wenn die Winkellage des Bezugssystems, wie erfindungsgemäß vorgesehen, elektrisch steuerbar ist, um bei einer Welle Polarisationskorrekturen oder Phasenänderungen innerhalb kürzester Zeit vornehmen zu können.

Beim in der Fig. 1 dargestellten Ausführungsbeispiel hängt, wie weiter oben beschrieben, die Lage des Bezugssystems x', y' von der Orientierung des quer zum Ferritkern 2 ausgerichteten Magnetfeldes B ab. Demzufolge kann also über ein axial drehbares Magnetfeld dem Bezugssystem jede beliebige Winkellage verliehen werden. Um ein solches Drehfeld zu erzeugen, ist außen um den Hohlleiter 1 ein Kranz mit Polschuhen 4, 5, 4', 5', 6, 7, 6', 7' mit Erregerwicklungen $W_4$, $W_5$, $W_{4'}$, $W_{5'}$, $W_6$, $W_7$, $W_{6'}$, $W_{7'}$ angeordnet. Von den die Erregerwicklungen durchfließenden Strömen $I_4$, $I_5$, $I_{4'}$, $I_{5'}$, $I_6$, $I_7$, $I_{6'}$, $I_{7'}$ hängt es nun ab, welche Lage das Drehfeld B einnimmt. Über eine entsprechende Steuerung der Ströme kann das Magnetfeld sowohl in diskrete Winkellagen versetzt, als auch einer kontinuierlichen Rotation mit wählbarer Winkelgeschwindigkeit ausgesetzt werden. Dies kann z.B. so erfolgen, daß die steuernden Ströme $I_4$, $I_{4'}$ der Polschuhe 4, 4' zeitlich abschwellen, während die Ströme $I_5$, $I_{5'}$ der Polschuhe 5, 5' anschwellen, so daß sich das äußere Magnetfeld B kontinuierlich in die durch B' angedeutete Lage dreht.

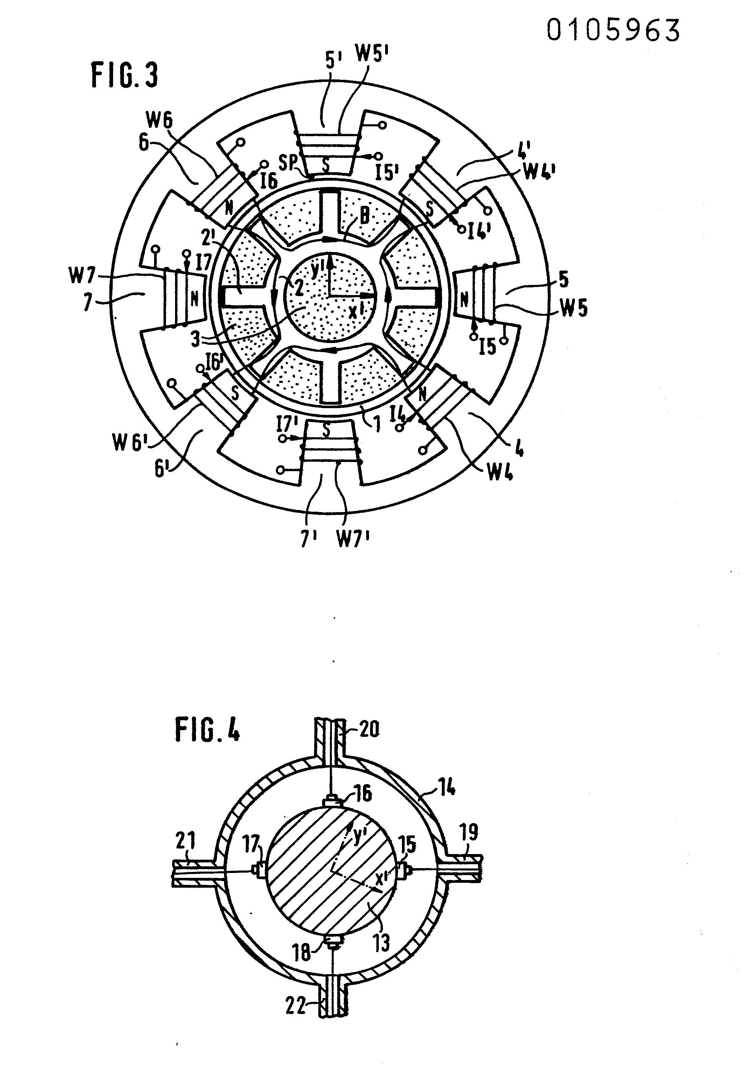

Die Fig. 3 zeigt einen Polarisationswandler, der gegenüber dem in Fig. 1 dargestellten so abgewandelt ist, daß der Ferritkörper bei der Erzeugung der unterschiedlichen Phasendrehungen in zwei orthogonalen Richtungen effektiver ausgenutzt wird. Außerdem ist der Ferritkörper so geformt, daß der magnetische Widerstand im Magnetsystem verringert wird.

Zur Erzeugung eines möglichst großen Unterschiedes der Phasendrehung in den orthogonalen Richtungen x', y' kann die Magnetisierung des Ferritkörpers so erfolgen, daß die Phasenkonstante der Welle mit Schwingungsrichtung y' vergrößert (verkleinert) und die Phasenkonstante der dazu senkrecht in x' Richtung orientierten Welle verkleinert (vergrößert) wird. Die entsprechende Konfiguration der Magnetfeldlinien B ist in Fig. 3 eingezeichnet.

Um eine diskrete Lage eines solchen Magnetfeldes und damit des Bezugssystems x', y' zu erzeugen, sind mindestens vier Polschuhe erforderlich. Es sind dies die Polschuhe 4, 4' und 6, 6'. Alle vier Polschuhe sind von der gleichen Amperewindungszahl durchflutet und haben über den Umfang verteilt abwechselnde Polarität S bzw. N. Alle die Windungen $W_4$, $W_{4'}$, $W_6$, $W_{6'}$ durchfließenden Ströme $I_4$, $I_{4'}$, $I_6$, $I_{6'}$, sind gleich groß nur müssen sie so gerichtet sein, daß die abwechselnde Polarität entsteht. Um nun ein drehbares Bezugssystem x', y' zu erzeugen, sind mindestens weitere vier Polschuhe 5, 5' und 7, 7' erforderlich, die in gleicher Weise wie die Polschuhe 4, 4' und 6, 6' durchflutet werden. Die beiden Polschuhsysteme 4, 4', 6, 6' und 5, 5', 7, 7' sind aber gegeneinander um 45° verdreht angeordnet. Eine Speisung beider Polschuhsysteme mit einem Zweiphasen-Drehstrom (zwei Ströme mit einer Phasendifferenz von 90°) erzeugt nun eine rotierende magnetische Fehlkonfiguration B der in Fig. 3 gezeigten Art. Natürlich kann das Magnetfeld in einer wählbaren Position festgehalten werden.

Die räumliche Winkelgeschwindigkeit des sich drehenden Magnetfeldes entspricht dabei der halben Winkelgeschwindigkeit des steuernden Drehstromes. Mit der gezeigten Anordnung von insgesamt 8 Polschuhen ist es also möglich, eine besonders hohe Differenz der Ausbreitungskonstanten in den Orthogonalebenen des Rundhohlleiters zu erzeugen.

Um den magnetischen Widerstand der Anordnung zu verringern, erhält der Ferritkörper die aus Fig. 3 ersichtliche spezielle Form. Dabei sind am Unfang des rohrförmigen Ferritkörpers 2 längs verlaufende Schenkel 2' angeordnet. Auf jeden Polschuh weist ein Schenkel 2' des Ferritkörpers. Somit ist der magnetische Widerstand der Wege, auf denen die magnetischen Feldlinien B verlaufen, verringert. Zum magnetischen Widerstand tragen auch die Luftspalte SP zwischen den Polschuhen und der Hohlleiterwandung bei. Die Luftspalte sollte daher möglichst gering und die Hohlleiterwandung möglichst dünn sein. Eine sehr dünne Hohlleiterwandung erhält man, wenn man die durch das Dielektrikums und die Ferritkörperschenkel gebildete Außenfläche mit einer Metallhaut beschichtet.

Es bleibt dem fachmännischen Können überlassen, die in Fig. 3 gezeigte Anordnung weiter zu modifizieren. Beispielsweise kann die Zahl der Polschuhe noch erweitert werden. Auch sind geometrische Veränderungen und Variationen der relativen Dielektrizitätskonstanten des Dielektrikums 3 denkbar, mit dem Ziel eine bestimmte Hohlleiterimpedanz und -grenzfrequenz zu erreichen. An den Enden der Polarisationsanordnung können, sofern es die Impedanzverhältnisse erfordern, dielektrische Impedanztransformationen vorgesehen werden, welche die Anpassung an die zuführenden und abführende Hohlleiteranordnung übernehmen.

Es sei darauf hingewiesen, daß auch der Ferritkörper in seiner Geometrie hinsichtlich größter hochfrequenter Wirksamkeit und kleinstem magnetischem Widerstand optimiert werden kann.

Sofern irgendwelche nichtlinearen Effekte (Hysterese der Polschuhe und des Ferritkörpers) auftreten, so können diese durch die Form der Steuerströme so beeinflußt werden, daß sie sich möglichst wenig störend auswirken.

Eine Magnetisierung der Schenkel 2' des Ferritkörpers kann vorgenommen werden durch stromdurchflossene Leiterschleifen, die auf den Schenkeln aufgewickelt oder in der Hohlleiterwandung integriert sind. Hierbei müssen aber die erregenden Leiterschleifen hochfrequenzmäßig abgeblockt werden. Damit läßt sich ein in diskrete Phasenzustände nach dem sogenannten Latching Prinzip umschaltbarer Phasenschieber realisieren.

Neben der Richtung des Magnetfeldes kann mittels der Steuerströme, das gilt für beide in Fig. 1 und Fig. 3 dargestellten Anordnungen, auch die Amplitude des resultierenden Magnetfeldes variiert werden. Über die Amplitudenvariation läßt sich nämlich das Achsenverhältnis einer Polarisationsellipse beliebig verändern.

Ein anderes Ausführungsbeispiel eines Polarisationswandlers mit einem elektrisch steuerbaren Bezugssystem zeigen die Figuren 4 (Vorderansicht) und 5 (perspektivische Seitenansicht). Dieser Polarisationswandler besteht aus einem Koaxial-Hohlleiter, zwischen dessen Innenleiter 13 und Außenleiter 14 mehrere Dioden 15, 16, 17, 18 - vorzugsweise Kapazitätsdioden - angeordnet sind. Die Dioden sind mit dem Innenleiter 13 kontaktiert und erhalten über durch den Außenleiter 14 hindurchgeführte koaxiale Zuführungsleitungen 19, 20, 21, 22 ihre Vorspannungen. Die Anordnung von 4 Dioden am Umfang ist nur ein Beispiel. Eine größere Zahl vereinfacht die kontinuierliche Drehung des Bezugssystems durch die Ansteuerung. Es müssen aber mindestens drei Dioden am Umfang verteilt angeordnet sein, sonst läßt sich kein drehendes Bezugssystem realisieren.

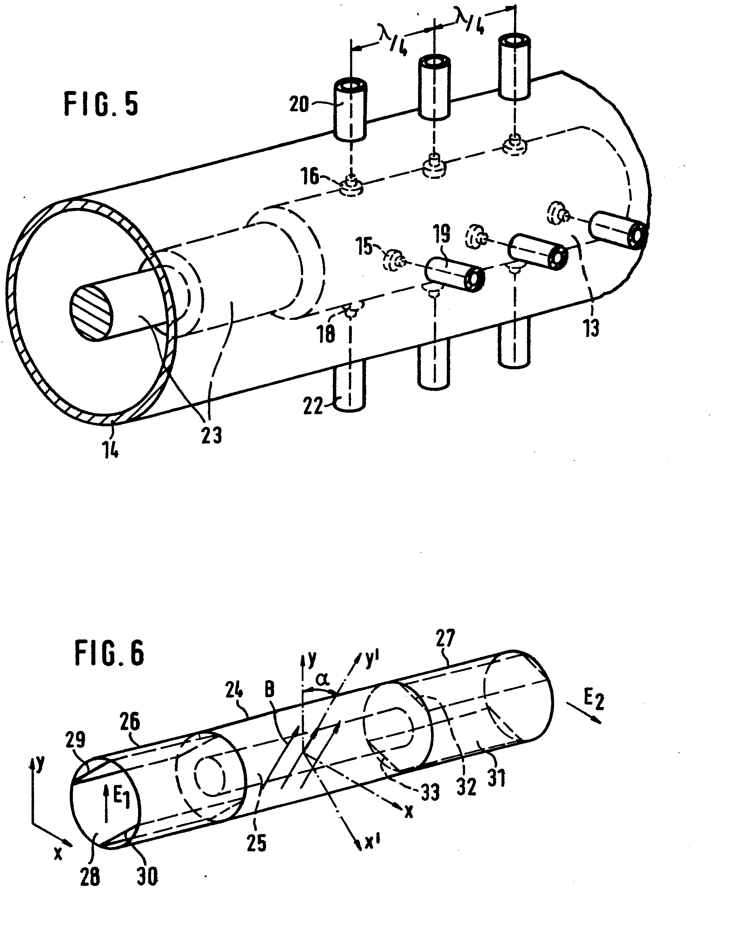

Das oben angesprochene Bezugssystem x', y' wird durch die kapazitiven Impedanzen der Dioden gebildet. Durch entsprechende Wahl der um den Innenleiter verteilten Diodenimpedanzen läßt sich auch hier dem Bezugssystem jede beliebige radiale Lage verleihen. Über die Vorspannungen, von denen die Diodenimpedanzen abhängen, kann das Bezugssystem wiederum sowohl in diskrete Winkellagen gebracht als auch einer kontinuierlichen Rotation mit wählbarer Winkelgeschwindigkeit ausgesetzt werden. Wie in der Fig. 5 angedeutet, sind längs der Hohlleiterachse im Abstand von jeweils $\lambda/4$ mehrere Querschnittsebenen vorgesehen, in denen mindestens drei transversal ausgerichtete Dioden angeordnet sind. Die Anzahl der mit Dioden bestückten Querschnittsebenen hängt davon ab, welche Phasenverschiebung zwischen den sich in den orthogonalen Längsschnittebenen des Bezugssystemes ausbreitenden Wellenkomponenten erreicht werden soll, ob z.B. ein 90°- oder ein 180°-Polarisationswandler realisiert werden soll.

Um Reflexionen an der Trennstelle, zwischen dem Koaxial-Hohlleiter und einem sich daran evtl. anschließenden anderen Hohlleiterbauelement zu vermindern, ist der Innenleiter 13 am Ende mit Abstufungen 23 versehen (vgl. Fig. 5). Es sei darauf hingewiesen, daß die Ausführungsform des Polarisationswandlers nach Fig. 4, 5 auch die Anwendungen zuläßt, die mit dem Polarisator gemäß Fig. 1 bis 3 möglich sind.

Im folgenden soll nun der Einsatz eines Polarisationswandlers als Phasenschieber nach dem aus der amerikanischen Patentschrift 2 607 849 bereits bekannten Prinzip erörtert werden. Dabei kann jede der in den Fig. 1 bis 4 vorgestellten Ausführungen des erfindungsgemäßen, elektrisch steuerbaren Polarisationswandlers verwendet werden.

Bei dem in Fig. 6 dargestellten Phasenschieber ist ein 180°-Polarisationswandler 24 eingesetzt, der gemäß der in Fig. 1 gezeigten Ausführung im Innern einen asymmetrisch quermagnetisierten Ferritkern 25 trägt. Vor und hinter diesem variablen 180°-Polarisationswandler ist jeweils ein 90°-Polarisationswandler 26 bis 27 angeordnet. Beide 90°-Polarisationswandler 26 und 27 brauchen nur ein starres Bezugssystem aufzuweisen. Ein derartiger Polarisationswandler mit festem Bezugssystem kann z.B. dadurch realisiert werden, daß in den Hohlleiter eine sich in Wellenausbreitungsrichtung erstrekkende dielektrische Platte eingesetzt wird (vgl. US-PS 2 607 849), oder daß, wie Fig. 6 zeigt, der Hohlleiter 26 bzw. 27 mit einem Dielektrikum 28 bzw. 31 ausgefüllt wird, das mit zwei einander gegenüberliegenden, parallel zur Hohlleiterachse verlaufenden Abflachungen 29 und 30 bzw. 32 und 33 versehen ist.

Der in Fig. 6 schematisch dargestellte Phasenschieber funktioniert folgendermaßen: Eine linear polarisierte Welle $E_1$ tritt in den ersten 90°-Polarisationswandler 26 ein. Aufgrund des Dielektrikums 28 mit gegenüber der Polarisationsebene der Welle $E_1$ um 45° geneigten Abflachungen 29 und 30 wird die Welle in eine zirkular polarisierte umgewandelt. Diese zirkular polarisierte Welle durchläuft dann den 180°-Polarisationswandler 24, in dem das Bezugssystem x', y' um einen Winkel $\alpha$ gegenüber der Polarisationsebene der eingespeisten Welle $E_1$ gedreht ist. Das in der Fig. 6 eingezeichnete Koordinatensystem x, y bezieht sich auf die Welle $E_1$ am Eingang des Phasenschiebers, wobei die y-Achse parallel und die x-Achse senkrecht zu der Polarisationsebene der Welle $E_1$ orientiert ist. Die am Ausgang des 180°-Polarisationswandlers erscheinende gegensinnig zirkular polarisierte Welle wird dann durch den sich anschließenden 90°-Polarisationswandler 27 in eine linear polarisierte Welle $E_2$ rückgewandelt. Die aus dem Phasenschieber austretende Welle $E_2$ hat wegen der Verdrehung des Bezugssystems des 180°-Polarisationswandlers um den Winkel $\alpha$ gegenüber der eintretenden Welle $E_1$ eine Phasenverschiebung von $2 \cdot \alpha$ erfahren. Besonders vorteilhaft ist die Tatsache, daß sich hiermit ein endlos drehender Phasenschieber aufbauen läßt.

Da der erfindungsgemäße, elektrisch steuerbare Polarisationswandler sehr schnelle und sehr große Phasenänderungen ermöglicht, läßt sich mit seinem Einsatz der soeben beschriebene Phasenschieber in vorteilhafter Weise als Phasenmodulator verwenden; so z.B. als digitaler Phasenmodulator, bei dem

0105963

eine Umtastung zwischen mehreren diskreten Phasenzuständen in Abhängigkeit entsprechend zugeordneter Bitworte erfolgt.

Da man das Bezugssystem x', y' des erfindungsgemäßen Polarisationswandlers mit einer wählbaren Winkelgeschwindigkeit $\frac{d\alpha}{dt}$ rotieren lassen kann, eröffnet sich die Möglichkeit, den in Fig. 5 dargestellten Phasenschieber als Frequenzwandler auszunutzen. Die Kreisfrequenz der austretenden Welle $E_2$ ändert sich gegenüber der Kreisfrequenz der eintretenden Welle $E_1$ um den Wert $2 \cdot \frac{d\alpha}{dt}$, wobei es von der Drehrichtung des Bezugssystems abhängt, ob die Kreisfrequenz um diesen Wert erhöht oder vermindert wird.

Eine weitere vorteilhafte Anwendung ergibt sich für den erfindungsgemäßen Polarisationswandler in einem Mikrowellenkombinator, wie er z.B. in Diversityempfangssystemen verwendet wird.

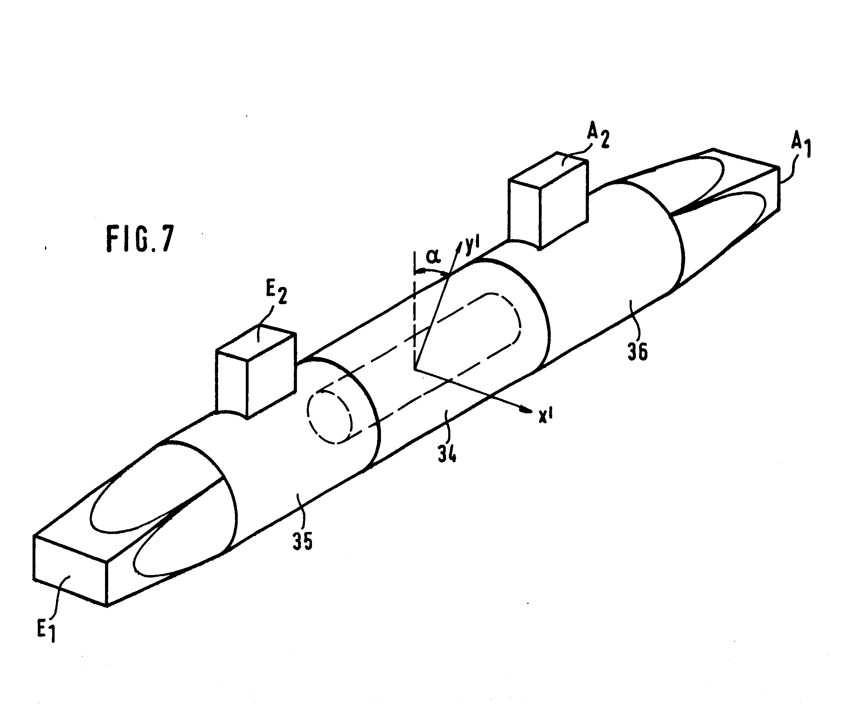

Wie die Fig. 7 zeigt, ist bei einem solchen Mikrowellenkombinator der Polarisationswandler 34 zwischen zwei Polarisationsweichen 35 und 36 angeordnet. Ein in eines der beiden Eingangstore $E_1$, $E_2$ der ersten Polarisationsweiche 35 eingespeistes Mikrowellensignal wird dabei, steuerbar durch den Polarisationswandler 34, mit beliebigem Leistungsverhältnis und beliebigem Phasenunterschied auf die beiden Ausgangstore $A_1$, $A_2$ der zweiten Polarisationsweiche 36 aufgeteilt.

Es sei darauf hingewiesen, daß beim Polarisationswandler gemäß Fig, 1, 2, 3 dem transversalen drehbaren Magnetfeld zusätzlich ein longitudinales Magnetfeld überlagert werden kann, wobei das longitudinale Feld eine Drehung des Bezugssystems und das transversale Feld aus einer eingespeisten linear polarisierten Welle eine elliptisch polarisierte Welle erzeugt.

- - - - -

- 1 -

AEG-TELEFUNKEN                                    K1 E7/Th/kön
Nachrichtentechnik GmbH                           BK 82/10
Gerberstr. 33
D-7150 Backnang


<u>Patentansprüche</u>


1. Polarisationswandler für Mikrowellen, bestehend aus einem Wellenleiter mit darin längs seiner Achse angeordneten Mitteln, die ein Bezugssystem bilden aus senkrecht aufeinanderstehenden Längsschnittebenen, in denen die orthogonalen Komponenten einer in den Wellenleiter eingespeisten Welle unterschiedlich große Phasendrehungen erfahren, wobei das Bezugssystem um die Längsachse des Wellenleiters drehbar ist, <u>dadurch gekennzeichnet,</u> daß diese Mittel aus einem Ferritkörper (2, 2') bestehen, daß ortsfest außen um den Wellenleiter (1) Erregerwicklungen ($W_4$, $W_5$, $W_{4'}$, $W_{5'}$, $W_6$, $W_7$, $W_{6'}$, $W_{7'}$,) tragende Polschuhe (4, 5, 4', 5', 6, 7, 6', 7') derart angeordnet sind, daß die die Erregerwicklungen durchfließenden Ströme ($I_4$, $I_5$, $I_{4'}$, $I_{5'}$, $I_6$, $I_7$, $I_{6'}$, $I_{7'}$,) ein zum Wellenleiter transversal ausgerichtetes, inhomogenes Magnetfeld (B) erzeugen, wobei in Abhängigkeit von den Strömen das Magnetfeld und damit das Bezugssystem (x', y') in jede beliebige radiale Richtung orientierbar ist.

0105963

BK 82710

2. Polarisationswandler nach Anspruch 1, dadurch gekennzeichnet, daß der Ferritkörper stabförmig ist.

3. Polarisationswandler nach Anspruch 1, dadurch gekennzeichnet, daß der Ferritkörper (2) rohrförmig ist.

4. Polarisationswandler nach Anspruch 1, dadurch·gekennzeichnet, daß der Ferritkörper im wesentlichen solche Längsschnittebenen im Wellenleiter (1) ausfüllt, in denen das magnetische Feld der sich in Längsrichtung des Wellenleiters ausbreitenden Welle zirkular polarisiert ist.

5. Polarisationswandler nach Anspruch 1, dadurch gekennzeichnet, daß der Ferritkörper (2) im Wellenleiter (1) in einem Dielektrikum (3) eingebettet ist.

6. Polarisationswandler nach Anspruch 1, dadurch gekennzeichnet, daß das Magnetfeld (B) in seiner Amplitude veränderbar ist.

7. Polarisationswandler nach Anspruch 1, dadurch gekennzeichnet, daß ein magnetischer Quadrupol aus vier Polschuhen (4, 4', 6, 6') mit alternierender Polarität (S, N) um den Wellenleiter herum angeordnet ist.

8. Polarisationswandler nach den Ansprüchen 1 oder 7, dadurch gekennzeichnet, daß ein weiterer magnetischer Quadrupol (5, 5', 7, 7') mit alternierender Polarität (S, N) um den Wellenleiter herum angeordnet ist, wobei dieser zweite Quadrupol gegenüber dem ersten um 45° verdreht ist.

9. Polarisationswandler nach einem der Ansprüche 1, 2 oder 3 dadurch gekennzeichnet, daß der Ferritkörper (2) an seinem Umfang längs verlaufende Schenkel (2') aus Ferritmaterial aufweist, die auf die einzelnen Polschuhe (4, 4', 5, 5', 6, 6', 7, 7') ausgerichtet sind.

10. Polarisationswandler nach Anspruch 9, dadurch gekennzeichnet, daß die Schenkel (2') des Ferritkörpers bleibend magnetisierbar sind mittels auf den Schenkeln aufgewickelter oder in der Wandung des Wellenleiters (1) integrierter, stromdurchflossener Windungen.

11. Polarisationswandler für Mikrowellen, bestehend aus einem Wellenleiter mit darin längs seiner Achse angeordneten Mitteln, die ein Bezugssystem bilden aus senkrecht aufeinanderstehenden Längsschnittebenen, in denen die orthogonalen Komponenten einer in den Wellenleiter eingespeisten Welle unterschiedlich große Phasendrehungen erfahren, wobei das Bezugssystem um die Längsachse des Wellenleiters drehbar ist, dadurch gekennzeichnet, daß in einem Koaxial-Wellenleiter in mindestens zwei Querschnittsebenen im Abstand von etwa $\lambda/4$ über den Umfang des Innenleiters (13) verteilt, mindestens drei Dioden (15, 16, 17, 18) angeordnet sind und daß den radial zwischen den Innen- (13) und dem Außenleiter (14) angeordneten Dioden von außen Vorspannungen zugeführt sind, über die die Lage des von den Diodenimpedanzen abhängigen Bezugssystems (x', y') einstellbar ist.

12. Polarisationswandler nach einem der vorhergehenden Ansprüche, dadurch gekennzeichnet, daß dieser so dimensioniert ist, daß die parallel zu den orthogonalen Achsen des Bezugssystems orientierten Komponenten einer den Polarisationswandler durchlaufenden Welle eine gegenseitige Phasenverschiebung von 180° erfahren.

13. Polarisationswandler nach Anspruch 12, dadurch gekennzeichnet, daß ein Phasenschieber realisiert ist, wobei der dem 180°-Polarisationswandler (24) ein 90°-Polarisationswandler (16) angeordnet ist, der eine linear polarisierte Welle ($E_1$) in eine zirkular polarisierte Welle umwandelt und wobei hinter dem 180°-Polarisationswandler ebenfalls ein 90°-Polarisationswandler (27) angeordnet ist, der die zirkular polarisierte Welle nach einer durch den 180°-Polarisationswandler bewirkten Drehrichtungsumkehr wieder in eine linear polarisierte Welle ($E_2$) umwandelt.

14. Polarisationswandler nach einem der vorhergehenden Ansprüche, gekennzeichnet durch die Verwendung als Phasenmodulator.

15. Polarisationswandler nach Anspruch 14, gekennzeichnet durch die Verwendung als digitaler Phasenmodulator, wobei den einzelnen Phasenzuständen diskrete Winkellagen des Bezugssystems zugeordnet sind.

16. Polarisationswandler nach einem der vorhergehenden Ansprüche, gekennzeichnet durch die Verwendung als Frequenzwandler, wobei das Bezugssystem mit einer die Frequenzänderungen bestimmenden Winkelgeschwindigkeit $\frac{d\,\alpha(t)}{dt}$ rotiert.

17. Polarisationswandler nach einem der Ansprüche 1 bis 10, dadurch gekennzeichnet, daß mit dem Polarisationswandler ein Mikrowellenkombinator realisiert ist, indem der Polarisationswandler (34) zwischen zwei Polarisationsweichen (35, 36) angeordnet ist.

0105963

FIG. 1

FIG. 2

0105963

**FIG. 3**

**FIG. 4**

0105963

**FIG. 5**

**FIG. 6**

FIG.7

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| | L. THOUREL: "Dispositifs a Ferrites Pour Micro-Ondes", 1969, Masson et Cie, PARIS (FR) | | H 01 P 1/17<br>H 01 P 1/195 |
| X | * Seiten 142-150; Paragraph 5.5: "Modulateur à bande latéral unique" * | 1-4,6,<br>7,12-<br>14,16,<br>17 | |
| Y | | 5 | |
| | -- | | |
| Y | FR - A - 2 095 198 (WESTERN ELECTRIC) | | |
| | * Seite 4, Zeilen 2-10; Abbildungen 3,4 * | 5 | |
| | -- | | **RECHERCHIERTE SACHGEBIETE (Int. Cl. ³)** |
| X | IEEE TRANSACTIONS ON MICROWAVE THEORY AND TECHNIQUES, Band MTT-19, Nr. 4, April 1971 NLW YORK (US) N.B. SULTAN: "Generalized Theory of Waveguide Differential Phase Sections and Application to Novel Ferrite Devices", Seiten 348-357. | | H 01 P |
| | * Das ganze Dokument * | 1,3,4,<br>6,7,<br>12-17 | |
| | -- | | |
| X | PATENTS ABSTRACTS OF JAPAN, Band 4, Nr. 141, 4 Oktober 1980, Seite 108 E 28 | | |
| | ./. | | |

~~Der vorliegende Recherchenbericht wurde für alle Patentansprüche erstellt.~~

| Recherchenort | Abschlußdatum der Recherche | Prüfer |
|---|---|---|
| Den Haag | 16-06-1983 | LAUGEL |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

0105963

Europäisches
Patentamt

## GEBÜHRENPFLICHTIGE PATENTANSPRÜCHE

Die vorliegende europäische Patentanmeldung enthielt bei ihrer Einreichung mehr als zehn Patentansprüche.

☐ Alle Anspruchsgebühren wurden innerhalb der vorgeschriebenen Frist entrichtet. Der vorliegende europäische Recherchenbericht wurde für alle Patentansprüche erstellt.

☐ Nur ein Teil der Anspruchsgebühren wurde innerhalb der vorgeschriebenen Frist entrichtet. Der vorliegende europäische Recherchenbericht wurde für die ersten zehn sowie für jene Patentansprüche erstellt für die Anspruchsgebühren entrichtet wurden,

nämlich Patentansprüche:

☐ Keine der Anspruchsgebühren wurde innerhalb der vorgeschriebenen Frist entrichtet. Der vorliegende europäische Recherchenbericht wurde für die ersten zehn Patentansprüche erstellt.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung; sie enthält mehrere Erfindungen oder Gruppen von Erfindungen, nämlich:

1. Patentansprüche 1-10,12-17; Polarisationswandler mit Ferritkörper.

2. Patentansprüche 11-16; Polarisationswandler mit Dioden.

☐ Alle weiteren Recherchengebühren wurden innerhalb der gesetzten Frist entrichtet. Der vorliegende europäische Recherchenbericht wurde für alle Patentansprüche erstellt.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind,

nämlich Patentansprüche:

☒ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen,

nämlich Patentansprüche: 1-10,12-17

# 0105963

| | EINSCHLÄGIGE DOKUMENTE | | KLASSIFIKATION DER ANMELDUNG (Int. Cl.³) |
|---|---|---|---|
| Kategorie | Kennzeichnung des Dokuments mit Angabe, soweit erforderlich, der Maßgeblichen Teile | betrifft Anspruch | |
| | & JP - A - 55 93 302 (MATSUSHITA)  * Abbildungen *  ---- | 1-4,6-8,14, 15 | |
| | | | RECHERCHIERTE SACHGEBIETE (Int. Cl.³) |

EPA Form 1503.2  06.78